# EUROPEAN PATENT APPLICATION

(11) **EP 0 740 160 A1**
(43) Date of publication of application: **30.10.1996**
(21) Application number: 95302731.5
(22) Date of filing: 24.04.1995
(51) Int. Cl.: G01R 1/073

(54) **Vertically operative probe card assembly**

(71) Applicant: NIHON DENSHIZAIRYO KABUSHIKI KAISHA, Amagasaki-shi, Hyogo (JP)
(72) Inventor: Okubo, Masao, Amagasaki-shi, Hyogo (JP); Kozaki, Shinichiro, Amagasaki-shi, Hyogo (JP); Sakata, Teruhisa, Amagasaki-shi, Hyogo (JP); Matsuoka, Keiji, Amagasaki-shi, Hyogo (JP); Matsumoto, Hiromi, Amagasaki-shi, Hyogo (JP); Osawa, Shigemi, Amagasaki-shi, Hyogo (JP)
(74) Representative: Beresford, Keith Denis Lewis

(57) **Abstract**

A vertically operative probe card for inspecting electrical characteristics of objectives of interest comprises a combination of a printed circuit board disposed in parallel with an objective of interest located downward and a probe card assembly including a plurality of probes extending vertically, downwardly from underside of the printed circuit board; the probe card assembly includes first spacer bars mounted vertically, downwardly from the underside of the printed circuit board, and a first lateral board connects down ends of the first spacer bars laterally in parallel with the printed circuit board; second spacer bars are mounted vertically, downwardly extending from the first spacer bars, and a second lateral board connects down ends of the second spacer bars laterally in parallel with the printed circuit board; the first and second lateral boards is provided with through holes in correspondence to locations and number of the probes to admit the probes to penetrate therethrough and to make contacts onto the objective of interest; each probe has a curve or laterally set U letter shaped portion which is heightwise received between the first and second lateral boards.

## Description

### Field of the Invention

The present invention relates to a probe card assembly with vertical movement for use to test electronic characteristics of integrated circuits (IC) formed on a semiconductor wafer or electronic elements, for example TAB, LED which will be generally noted objectives of interest in the following.

### Description of Related Art

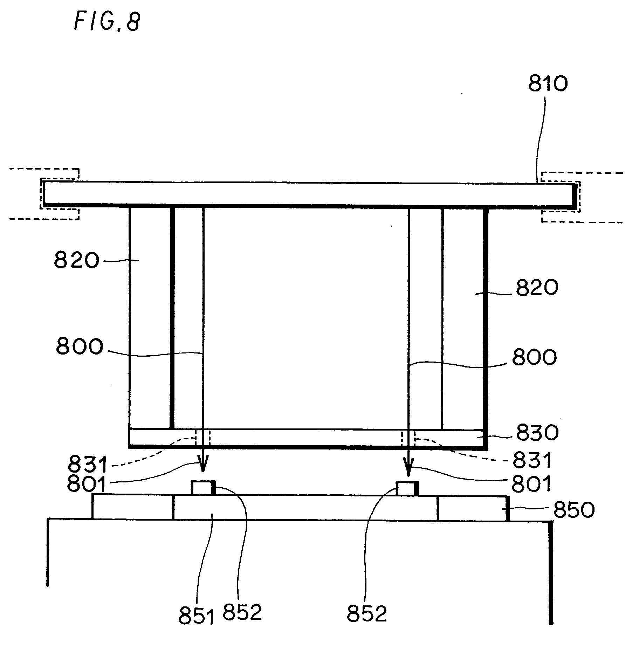

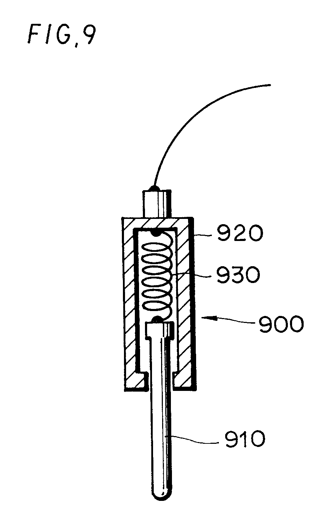

A conventional probe card assembly with vertical movement will be described with reference to Figs. 8 and 9. In Fig. 8, a wafer 850 is placed on a substrate (unnumbered) and ICs 851 are formed on the wafer 850 and provided with protuberant electrodes 852, 852 which will make a contact with a probe tip for the purpose of testing the ICs 851. Provided thereabove is a combination of a printed circuit board and a probe card assembly including a plurality of probes 800. Specifically, the numeral 810 indicates a printed circuit board carried at two sides by a lifter device (unnumbered and shown by dotted lines). Thereby the printed circuit board 810 is held lateral or in parallel with the wafer 850, and from an underside of the printed circuit board 810, two vertical spacer bars 820, 820 extend downward and a board 830 is laterally mounted connecting the down ends of the vertical spacer bars 820, 820.

Note: In the following, the term "printed circuit board 810" will be often shortened to "printed board 810", or further to "board 810", and "vertical spacer bar 820" will be also shortened to "vertical bar 820" for simplicity as far as readily understandable by dint of collocation with reference numbers, and further later appearing new terms will be handled in a similar manner.

The board 830 has a plurality of through holes 831 to match the number and locations of the probes wherein two probes 800, 800 are shown. Each probe 800 extends from the underside of the printed board 810 and penetrates through the hole 831 to let each probe front tip 801 be superjacent to each electrode 852, wherein the probe front tip 801 is sharpened which is symbolized by an arrow head mark in the drawing, and a probe back end is connected to an IC for the testing (such connection is abbreviated). Then the printed board 810 and the probe card assembly including vertical bars 820, lateral board 830 and probes 800 are connected so as to move unitary, wherein each hole 831 has a slightly larger diameter than that of the probe 800 so that the hole 831 will provide some latitude but will control dilatation of the probe 800 and in turn will control the contact point of the pinpoint probe 800 while the probe front tip 801 is pressed onto the electrode 852. In operation, testing is prepared by coming down of the vertically operative assembly.

However, problems have been found with the conventional probe card assembly with vertical movement as described. That is, the probe 800 applied is in a form of straight needle which will in operation undergo an "overdrive" or "impact pressure" after contact onto the electrode 852 for stable seating thereon. This additional press causes a dogleg flexing or buckling over the whole longitudinal length of the probe 800 and a significant pressure bears onto the electrode 852 and such pressure normally exceeds a desirable level which is realized by a cantilever type probe as illustrated in U.S. Patent 5134365. In order to obtain a suitable seating pressure, vertical straight probes should be made longer, but this countermeasure increases the height of the probe card assembly and thus results in inconvenience.

Further it is difficult to predict in which lateral direction the buckling or dilatation will take place. Normally at random. Therefore laterally dilated probes in neighborhood will possibly contact each other and thus results in failure of the testing.

Shown in Fig. 9 is another conventional art or another probe 900 which comprises the connection of a pin 910 and a laterally coiled spring 930 sheathed with a cylinder 920. This art avoids the buckling by use of the spring 930. However, the sheathing cylinder 920 is necessary in this art and thereby the lateral area occupied by one unit of the probe 900 is significantly made larger. This factor hinders denser arrangement or integration of the probes.

### Summary of the Invention

The present invention is directed to overcoming such drawbacks attendant on the conventional art and offers a probe card assembly which bears the seating pressure in the order approximate to that of the cantilever type and does not inconvenience denser arrangement of the probes as the state of art demands.

In the present invention, the art starts with a probe material in a form of thin straight needle made of a metal, for example tungsten and a probe is preformed with a cushioning flex at a local midportion on its longitudinal length to reduce a seating pressure and to afford predictability as to in which lateral direction further flexing or bucking will take place, with convenience in application to a probing equipment without bringing a large change in the conventional structure of a probe card assembly for vertical operation.

### Brief Description of the Drawings

Fig. 1 shows a schematic front view of a vertically operative probe card assembly belonging to the first embodiment of the present invention.

Fig. 2 shows a perspective view of a piece of the probe as incorporated in the assembly shown in Fig. 1.

Fig. 3 shows a perspective view of the probe shown in Fig. 2 in a state of being buckled.

Fig. 4 shows a few bottom views to explain directions as a result of the buckling with a plurality of probes in an arrangement.

Fig. 5 shows a schematic front view of a vertically operative probe card assembly belonging to the second embodiment of the present invention.

Fig. 6 shows a perspective view of a piece of the probe as incorporated in the assembly shown in Fig. 5.

Fig. 7 shows a front view of the probe shown in Fig. 6 in a state of being bent.

Fig. 8 shows a schematic front view of a conventional probe card assembly for vertical operation.

Fig. 9 shows a schematic sectional view of a conventional probe for vertical operation.

These drawings are presented to illustrate the invention and therefore these should not be construed as limiting the invention.

### Description of the Embodiments of the Present Invention

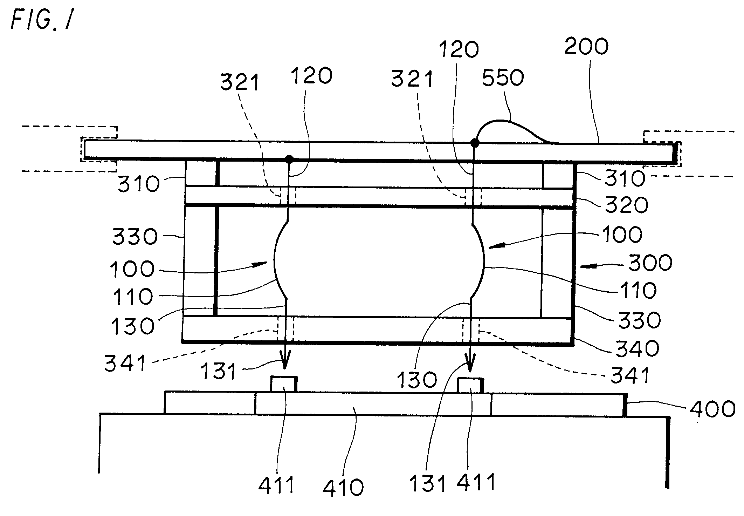

By analogy from the explanation of Fig. 8 showing the conventional probe card assembly as well as the description of summary of the invention, these being noted in the previous paragraphs, general conception of Fig. 1 is readily yielded by a reader. That is, the numeral 400 indicates a semiconductor wafer; 410 does ICs; 411, 411 do protuberate electrodes; 200 does a printed circuit board; 300 does a probe card assembly as a whole; 310, 310 do first vertical spacer bars; 320 does a first lateral board with through holes 321, 321, and 330, 330 do second vertical spacer bars; 340 does a second lateral board with through holes 341, 341; It is therefore recognized that there are two laterally connecting boards 320, 340, and the through holes 321, 341 have a slightly larger diameter than that of the probe for controlling lateral dilatation of the pinpoint probe and in turn controlling the position of the probe front tip in much the same way as noted in connection with the conventional art in Fig. 8.

Turning to a probe, 100 indicates a probe as a whole; 120 does an upper straight portion; 130 does a lower straight portion; 131 for an arrow mark does sharpened front tip; 110 does a bent or arcuate portion at midway in the longitudinal length of the probe, wherein the probe at left has the back end on the underside of the board 200 and the probe at right has the back end on the upper side thereof. 550 indicates an electrical lead to connect the probe back end with an electrical end on the printed board 200.

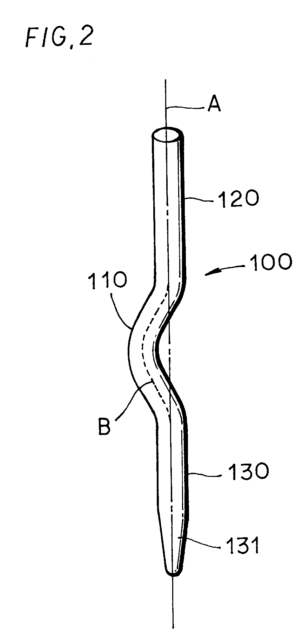

The probe 100 of this embodiment features in a curve or arc 110 provided at midportion of the probe longitudinal length so that the curve portion 110 is heightwise received between the two lateral boards 320, 340 and the upper straight portion 120 and the lower straight portion 130 are aligned to form a straight line A as shown in Fig. 2. Therewith assuming another axis B which runs through the curve portion, the axes A and B define one plane.

In operation, by analogy from the operation described in connection with the probe card assembly shown in Fig. 8, the probe card assembly 300 comes down as being carried by a lifter device of the probing equipment (dotted line, further is not shown) and first the front tips 131 of the probes 100 make contacts onto the electrodes 411, and then the overdrive act is taken, and thereby the tips 131 make the seating pressure, and at the same time, the probes 100 are buckled.

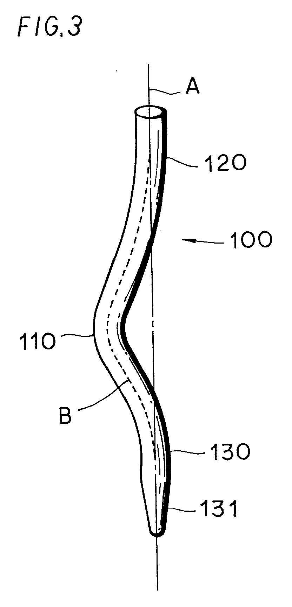

Referring further to the probe 100 with reference to Figs. 2 and 3 wherein a piece of probe is depicted as a whole in much compressed style vertically to suit the paper size. Assuming that the probe 100 has a figure as in Fig. 2 at the time of being incorporated in the probe card assembly or prior to subjecting to buckling action, Fig. 3 shows the same probe in a state of being buckled in the operation. Therein it is recognized that the buckling or dilatation of the curve portion is caused or occasioned toward growing the curvature on the plane defined by the axes A and B, and thus the question as to in which direction the buckling will take place is made predictable.

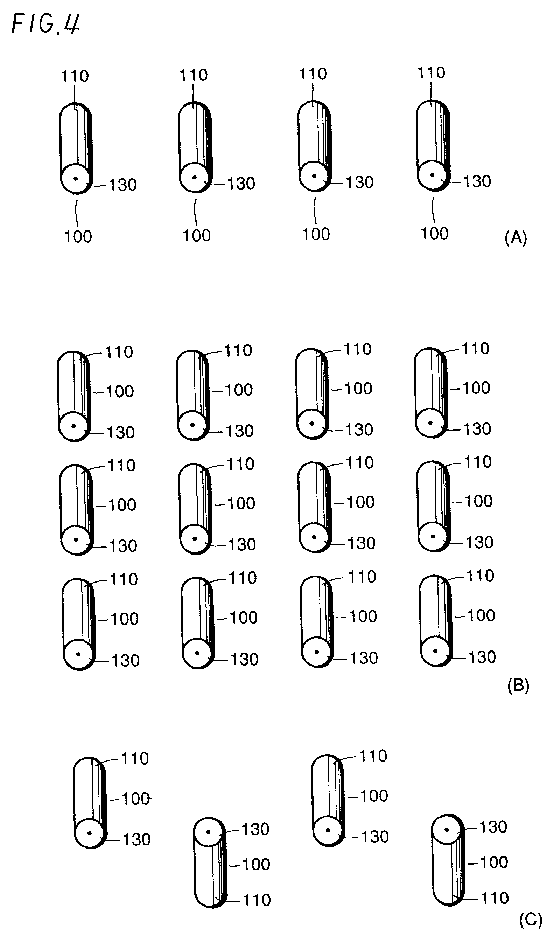

Turning to Fig. 4 which is intended to explain that a dense arrangement of the probes is allowable, based on the predictability of the buckling trend of the probes. Therein three ways of arrangements including (A), (B) and (C) are illustrated, wherein the view is from bottom and thus the front tip 130 is near end and the curve portion 110 is midway leading to the back end 120 which is not apparent. Specifically, (A) shows four (4) pieces laterally arranged are with the same buckling. (B) shows twelve (12) pieces arranged in three (3) lines are with the same buckling. (C) shows four (4) pieces arranged laterally are with alternative buckling trend. Such fine arrangement without fear of possible contact between adjacent pieces is enabled by dint of the predictability of the buckling in the present invention.

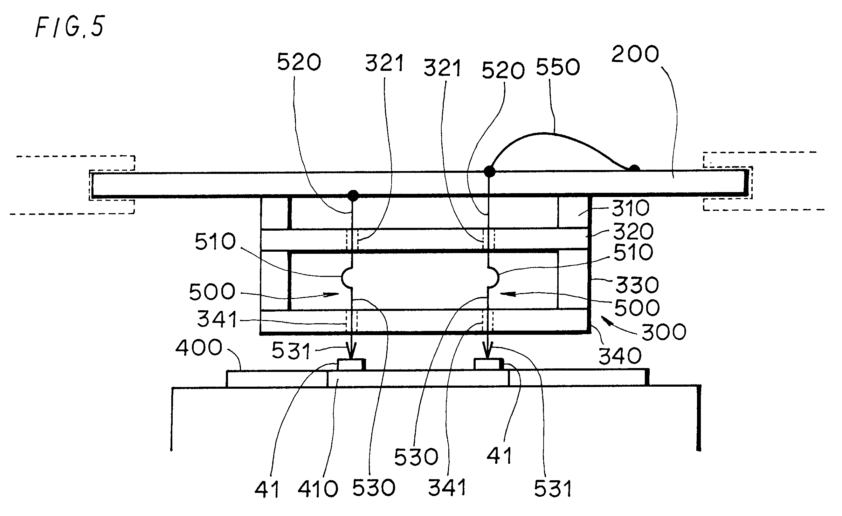

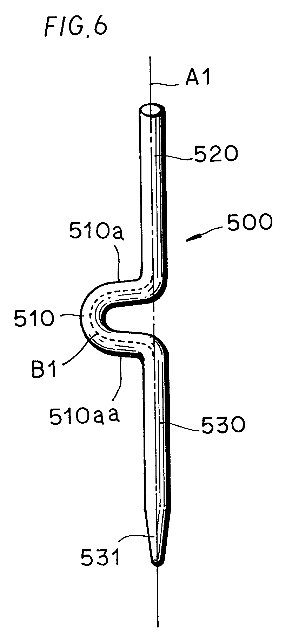

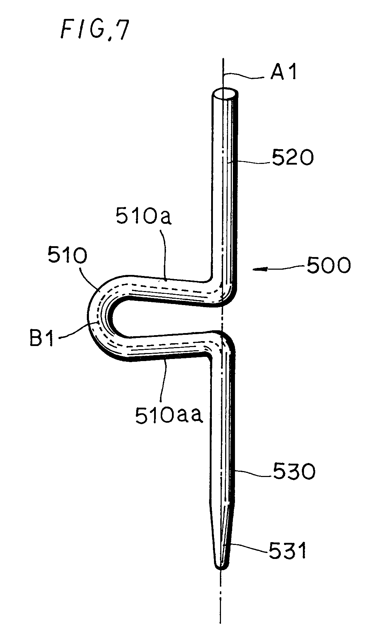

Now the second embodiment covered in Figs. 5, 6 and 7 will be described. As comparative review of Fig. 5 with Fig. 1 readily makes it apparent, this embodiment features in another figure of a probe 500 which includes a curve portion 510, upper straight portion 520, lower straight portion 530 and front tip 531, wherein the curve portion 510 takes a figure like the U letter fallen to the side wherein two subportions 510a and 510aa of the curve portion 510 are generally parallel or converging and this figuration renders the curve portion 510 substantially to act as a vertical spring with one cushion unit, and further two axes A1 and B1 define one plane as noted in connection with Fig. 2. In operation, a vertical spring will produce little force active to laterally when acted vertically, as compared with the probe employed in the first embodiment.

In conclusion, the vertically operative probe cards of the present invention are intended to apply to inspection of electronic characteristics of ICs formed on a semiconductor wafer, for example and the probes which will contact vertically onto electrodes formed on ICs are preformed with buckled or curved portions. Accordingly, the vertically operative probes of the present invention are made shorter in height. This convenience allows the vertically operative probe card assembly to be substantially the same size as the cantilever type probe card assembly and the preformed buckled or curved portion reduces the impact pressure down to a level approximate to the cantilever type, typically several grams to several tens grams.

Further, in the case of the first embodiment of the present invention, in the state that the probes are subjected to further buckling in the operation, little fear is expected of producing a contact between adjacent probes, since the arrangement can be determined, for instance, in a substantially same direction or in opposite directions as a result of utilization of the prediction as to in which direction the probes will dilate. This management in arranging the probes provides for denser or more compact probe card design.

In the case of the second embodiment of the present invention, the curve portion takes a figure like a laterally set U letter, wherein two subportions of the U portion are substantially parallel or converging each other, and this figuration produces a vertically active cushion spring and thereby a force acting in lateral directions is avoided. This avoidance will improve accurate positioning of the probe front tip onto the electrode.

It is further understood by those skilled in the art that the foregoing description is a preferred embodiment of the disclosed invention and that various changes and modifications may be made in the present invention without departing from the spirit and scope thereof.

## Claims

1. A vertically operative probe card for inspecting electrical characteristics of objectives of interest comprising a vertically movable probe to make a contact onto an electrode formed with the objective, the probe being a thin wire provided with a curve or laterally set U letter portion.

2. A vertically operative probe card as defined in claim 1, wherein the curve or laterally set U letter portions of adjacent probes are arranged so as to buckle in the same direction.

3. A vertically operative probe card as defined in claim 1, wherein the curve or laterally set U letter portions of adjacent probes are arranged so as to buckle in opposite directions.

4. A vertically operative probe card for inspecting electrical characteristics of objectives of interest comprising: a combination of a printed circuit board disposed in parallel with an objective of interest located downward and a probe card assembly including a plurality of probes extending vertically, downwardly from an underside of the printed circuit board; the probe card assembly including first spacer bars mounted vertically, downwardly from the underside of the printed circuit board, and a first lateral board connecting down ends of the first spacer bars laterally in parallel with the printed circuit board; second spacer bars mounted vertically, downwardly extending from the first spacer bars, and a second lateral board connecting down ends of the second spacer bars laterally in parallel with the printed circuit board; the first and second lateral boards being provided with through holes in correspondence to locations and number of the probes to admit the probes to penetrate therethrough and to make contacts onto the objective of interest;
each probe having a curve or laterally set U letter shaped portion which is heightwise received between the first and second lateral boards.

5. A vertically operative probe card as defined in claim 4, wherein the curve or laterally set U letter portions of adjacent probes are arranged so as to buckle in the same direction.

6. A vertically operative probe card as defined in claim 4, wherein the curve or laterally set U letter portions of adjacent probes are arranged so as to buckle in opposite directions.

7. A probe card carrying at least one probe adapted to make electrical contact with a circuit to be tested wherein the or each probe is arranged to distort in a predetermined manner on contact.
